# DEMANDE DE BREVET EUROPEEN

(11) **EP 1 818 973 A1**
(43) Date de publication de la demande: **15.08.2007**
(21) Numéro de dépôt: 07102096.0
(22) Date de dépôt: 09.02.2007
(51) Int. Cl.: H01L 21/20, H01L 29/786, H01L 21/336

(54) **Formation d'une portion de couche semiconductrice monocristalline séparée d'un substrat**

(30) Priorité: 10.02.2006 FR 0650474
(71) Demandeur: ST MICROELECTRONICS S.A., 92120 Montrouge (FR)
(72) Inventeur: Dutartre, Didier, 38240, MEYLAN (FR); Loubet, Nicolas, 38000, GRENOBLE (FR); Talbot, Alexandre, 38100, GRENOBLE (FR)
(74) Mandataire: de Beaumont, Michel

(57) **Abrégé**

L'invention concerne un procédé de formation d'une portion de couche semiconductrice monocristalline (40) au dessus d'une zone évidée, comprenant les étapes consistant à faire croître par épitaxie sélective sur une région active semiconductrice monocristalline (32) une couche semiconductrice monocristalline sacrificielle (38) et une couche semiconductrice monocristalline (40), et éliminer la couche sacrificielle (38). La croissance épitaxiale est réalisée alors que la région active est entourée d'une couche isolante en surépaisseur (34) et l'élimination de la couche semiconductrice monocristalline sacrificielle (38) est effectuée par un accès résultant d'une élimination au moins partielle de la couche isolante en surépaisseur.

## Description

### Domaine de l'invention

La présente invention concerne la formation d'une portion de couche semiconductrice monocristalline mince séparée d'un substrat semiconducteur monocristallin par un vide ou une ou plusieurs couches non monocristallines.

### Exposé de l'art antérieur

Dans de nombreux dispositifs semiconducteurs, il est souhaitable de disposer d'au moins une zone semiconductrice monocristalline mince séparée d'un substrat semiconducteur monocristallin par un vide ou une ou plusieurs couches de différentes natures et notamment des couches isolantes et/ou conductrices.

Pour cela, un procédé connu consiste à faire croître une première couche monocristalline sacrificielle sur un substrat monocristallin et une seconde couche monocristalline sur la première. Après quoi la couche sacrificielle est éliminée et le volume qu'elle occupait est éventuellement rerempli, partiellement ou totalement, d'un ou plusieurs matériaux.

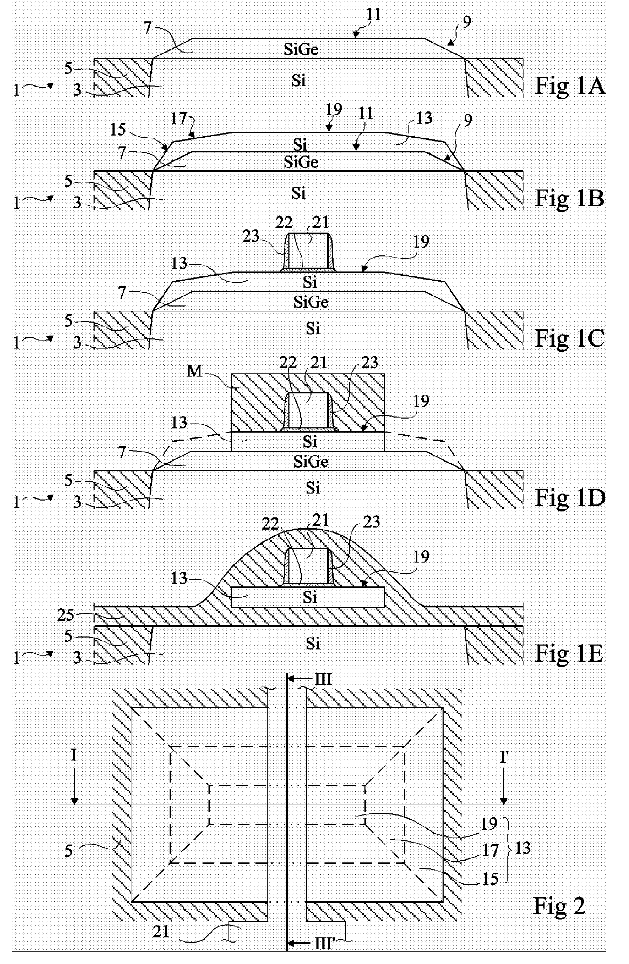

Les figures 1A à 1E sont des vues en coupe illustrant différentes étapes d'un procédé de fabrication connu d'un transistor MOS sur/dans une couche de silicium monocristallin très mince isolée d'une tranche semiconductrice sous-jacente.

La figure 1A représente une tranche semiconductrice de silicium monocristallin 1 dans laquelle des régions actives 3 sont définies par des zones d'isolement 5. Les zones 5 sont généralement des tranchées creusées dans la tranche 1 puis remplies d'un matériau isolant.

Après quoi on fait croître une couche semiconductrice monocristalline sacrificielle 7. La couche 7 est par exemple une couche de silicium-germanium (SiGe) contenant de 20 à 40 % de germanium. A proximité de la périphérie isolante constituée par les zones d'isolement 5, le silicium-germanium croît avec un angle qui tend à l'éloigner de la périphérie 5. Cela conduit à un facettage 9 de la périphérie. Au niveau du facettage 9, la couche sacrificielle 7 présente une épaisseur irrégulière. Seule la partie centrale horizontale 11 de la couche sacrificielle 7 est homogène en épaisseur.

Ensuite, comme l'illustre la figure 1B, une couche semiconductrice monocristalline de silicium 13 est formée sur la couche sacrificielle 7. La couche 13 présente généralement un double facettage. La figure 1B et les suivantes illustrent un tel double facettage, étant entendu que la couche de silicium 13 peut présenter un simple facettage ou un facettage plus complexe. Un facettage 15 est lié à la croissance de la couche 13 à proximité de la périphérie isolante 5 et à la présence du facettage sous-jacent 9. Un autre facettage 17 se trouve à la périphérie d'un plateau central 19 de la couche 13 qui croît sur la partie centrale 11 de la couche 7.

Ensuite, comme l'illustre la figure 1C, la grille 21 d'un transistor est formée sur la couche 13. La grille 21 est isolée de la couche 13 sous-jacente par un isolant mince 22 et est entourée d'un espaceur latéral périphérique isolant 23. Des implantations de source/drain sont effectuées.

La figure 2 est une vue de dessus correspondant à la figure 1C. On y voit les régions facettées 15 et 17 autour de la partie centrale 19 de la couche 13 et la grille isolée 21 qui traverse la région active 3 et s'appuie sur les zones d'isolement 5. On notera que les figures 1A à 1E sont des vues en coupe selon l'axe I-I' perpendiculaire à l'axe d'extension de la grille 21. Comme l'illustre la figure 2, la grille 21 passe deux fois sur les facettages 15 et 17 représentés en traits pointillés.

A ce stade du procédé, on souhaite retirer la couche sacrificielle de silicium-germanium 7. Toutefois, comme l'illustre la vue en coupe de la figure 1C, la couche de SiGe 7 est toujours revêtue de la couche de Si 13. Pour pouvoir accéder à la couche de SiGe 7, il faut donc retirer localement la couche de Si 13.

Pour ce faire, comme l'illustre la figure 1D, il faut former un masque spécifique M présentant une dimension supérieure à celle de la grille 21 mais inférieure à celle de la couche 13. Le masque M est généralement conçu pour ne recouvrir que partiellement la partie centrale 19 de la couche 13 de part et d'autre de la grille 21. La portion périphérique, illustrée en traits pointillés, de la couche de silicium 13 est retirée de façon que la couche sacrificielle sous-jacente 7 soit partiellement découverte.

Ensuite, avant ou après retrait du masque M, on procède à une gravure propre à éliminer sélectivement la couche de silicium-germanium 7. Après retrait de la couche 7, la couche 13 est maintenue en place par la grille supérieure 21 qui s'appuie sur les zones d'isolement 5. L'intervalle vide créé par le retrait de la couche 7 est alors conservé pour obtenir un substrat de silicium sur rien ou comblé par tout élément approprié.

Par exemple, comme l'illustre la figure 1E, on dépose un matériau isolant 25 qui remplit l'intervalle entre la couche de Si 13 et le substrat de Si 3.

On obtient alors un transistor MOS comportant une grille isolée 21 et ayant une région de canal 13 d'une faible épaisseur, généralement comprise entre 5 et 20 nm, de préférence inférieure à 10 nm, typiquement de l'ordre de 6 à 7 nm, sur un isolant localisé 25 de faible épaisseur comprise entre 10 et 30 nm, de préférence environ 10 nm.

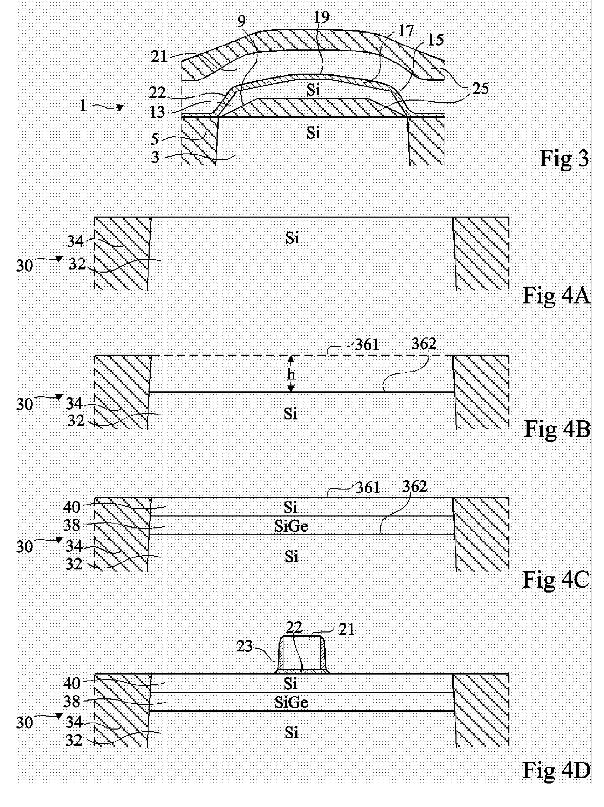

Un tel procédé présente divers inconvénients qui seront détaillés en relation avec la figure 3 qui illustre la structure de la figure 1E vue en coupe selon le plan III-III' de la figure 2 parallèle à l'axe d'extension de la grille 21, perpendiculaire à l'axe I-I' de coupe des figures 1A à 1E. Ainsi, la partie de la couche de silicium 13 illustrée en figure 3 correspond à une section de la région de canal sous la grille 21.

On voit en figure 3 que le canal du transistor MOS constitué par la couche 13 présente des amincissements importants de part et d'autre de sa partie centrale 19 en raison de l'existence des facettages susmentionnés 9, 15 et 17. De plus, ces amincissements se produisent à un emplacement où l'isolant 25 séparant le canal 13 de la région active sous-jacente 3 présente également un amincissement. De tels amincissements du canal 13 et de l'isolant 25 provoquent notamment deux types de dysfonctionnement.

D'une part, aux zones amincies du canal correspond un transistor MOS parasite dont la tension de seuil est bien inférieure à celle du transistor principal central formé au niveau de la partie horizontale 19 de la couche 13. La mise en conduction prématurée involontaire du transistor parasite périphérique par rapport au transistor central est particulièrement désavantageuse.

D'autre part, l'amincissement de l'isolant 25 provoque à proximité de la périphérie 5, c'est-à-dire à l'emplacement où la structure est la plus fragile, un resserrement important des lignes équipotentielles dans l'isolant 25. L'isolant 25 est susceptible de claquer et de provoquer une mise en court-circuit du canal 13 et de la région active sous-jacente 3.

Un autre inconvénient de la formation des facettages réside dans la réduction pyramidale de la surface horizontale, centrale de la couche supérieure. Ainsi, il ressort des figures 1A à 1E et 3 que la partie centrale horizontale 11 de la couche 7 est réduite par rapport à la surface de la région active 3. De façon similaire, comme l'illustrent les figures 1B à 1E, 2 et 3, la partie centrale 19 de la couche 13 est encore plus réduite. En vue en coupe, par rapport à la région active 3, la partie centrale 19 perd de chaque côté de deux à trois fois la somme des épaisseurs des couches 7 et 13. Ainsi, si l'empilement des couches 7 et 13 présente une épaisseur totale de l'ordre de 30 nanomètres, on perd de 60 à 90 nm de chaque côté soit un total de 120 à 180 nm. Lors de la conception des circuits il faut tenir compte de cette réduction de surface utile par rapport à la surface de la région active 3. Cela constitue un obstacle à la réduction des dimensions des dispositifs.

En outre, la surface perdue augmente avec l'augmentation du nombre de couches superposées. Cela est particulièrement gênant lors de la réalisation de structures multicouches telles que, par exemple, des transistors à grilles multiples. Cette surface perdue augmente également du fait qu'il faut prévoir une étape de masquage non autoalignée.

On se heurte aux mêmes problèmes que ceux décrits précédemment lors de la réalisation de transistors présentant une grille de type tout autour (all around gate) dans laquelle la grille est formée tout autour d'une zone de canal. Dans ce cas, l'intervalle vide résultant du retrait de la couche 7 est comblé par un isolant et un conducteur de grille qui entourent le canal 13.

La présente invention vise par conséquent à proposer une structure de couches monocristallines minces superposées parmi lesquelles on veut éliminer une couche sacrificielle, qui pallie au moins certains des inconvénients des structures connues.

La présente invention vise également à proposer un procédé de fabrication de transistors MOS dont la région de canal présente une épaisseur homogène et soit séparée d'une tranche semiconductrice sous-jacente par au moins une couche non monocristalline d'épaisseur homogène.

### Résumé de l'invention

Pour atteindre ces objets et d'autres, la présente invention prévoit un procédé de formation d'une portion de couche semiconductrice monocristalline au dessus d'une zone évidée, comprenant les étapes consistant à faire croître par épitaxie sélective sur une région active semiconductrice monocristalline une couche semiconductrice monocristalline sacrificielle et une couche semiconductrice monocristalline, et éliminer la couche semiconductrice monocristalline sacrificielle. La croissance épitaxiale est réalisée alors que la région active est entourée d'une couche isolante en surépaisseur et l'élimination de la couche semiconductrice monocristalline sacrificielle est effectuée par un accès résultant d'une élimination au moins partielle de la couche isolante en surépaisseur.

Selon un mode de réalisation de la présente invention, la région active semiconductrice monocristalline et la couche semiconductrice monocristalline sont en silicium, et la couche sacrificielle est en silicium-germanium.

Selon un mode de réalisation de la présente invention, la région active est initialement délimitée par une zone d'isolement au même niveau que sa face supérieure, et le procédé comprend, avant l'épitaxie desdites couches, l'étape consistant à abaisser la surface supérieure de la région active d'une hauteur inférieure à la profondeur desdites zones d'isolement.

Selon un mode de réalisation de la présente invention, la hauteur d'abaissement de la surface supérieure de la région active est sensiblement égale à la somme des épaisseurs des couches épitaxiées.

Selon un mode de réalisation de la présente invention, la région active est initialement délimitée par une zone d'isolement formée au-dessus d'une couche ou substrat semiconducteur.

Selon un mode de réalisation de la présente invention, l'intervalle vide laissé par le retrait de la couche sacrificielle est rempli d'un isolant.

Selon un mode de réalisation de la présente invention, l'intervalle vide laissé par le retrait de la couche sacrificielle est rempli d'un matériau conducteur électrique ou thermique tel qu'un métal.

La présente invention s'applique à la formation d'un transistor MOS à une ou plusieurs grilles.

Selon un mode de réalisation de la présente invention, le retrait de la couche sacrificielle est effectué après formation d'une grille isolée sur ladite couche semiconductrice monocristalline.

Selon un mode de réalisation de la présente invention, la formation de la grille est suivie d'une étape de croissance épitaxiale d'un matériau semiconducteur monocristallin de même nature que celui du canal, destiné à constituer des zones de source/drain surélevées.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1E, décrites précédemment, illustrent en vue en coupe, différentes étapes de formation d'un transistor MOS selon un procédé connu ;
la figure 2, décrite précédemment, est une vue de dessus de la figure 1C ;
la figure 3, décrite précédemment, est une vue en coupe de la structure de la figure 1E selon le plan III-III' de la figure 2 ;
les figures 4A à 4F sont des vues en coupe de différentes étapes de formation d'un transistor MOS selon un mode de réalisation de la présente invention ;
la figure 5 est une vue en coupe de la structure de la figure 4F dans un plan de coupe perpendiculaire ; et
les figures 6A et 6B représentent une variante d'étapes préliminaires de mise en oeuvre d'un procédé selon l'invention.

### Description détaillée

Comme cela est habituel dans la représentation des composants semiconducteurs, les diverses figures ne sont pas tracées à l'échelle. En outre, on notera que les matériaux isolants ont été représentés hachurés dans les différentes figures.

Une application à la formation d'un transistor MOS à simple grille d'un procédé selon un mode de réalisation de la présente invention est décrite ci-après en relation avec les vues en coupe des figures 4A à 4F et 5.

La figure 4A est une vue en coupe d'une tranche semiconductrice monocristalline 30 comportant une région active 32 délimitée par des zones d'isolement 34. La tranche 30 est par exemple en silicium monocristallin. Les zones 34 sont constituées de tranchées peu profondes remplies d'isolant (STI).

Comme l'illustre la figure 4B, on grave la région active 32 sélectivement par rapport aux zones d'isolement périphériques 34. Cette gravure est effectuée par tout procédé de gravure de silicium, par exemple un procédé de gravure sèche par plasma isotrope ou anisotrope, ou un procédé de gravure chimique humide, ou encore un procédé de gravure en phase gazeuse en présence d'acide chlorhydrique gazeux réalisable dans le réacteur d'épitaxie. La surface supérieure de la région 32 est abaissée d'une hauteur h, du niveau 361 au niveau 362. La hauteur h est choisie notamment de façon à être inférieure à la profondeur des zones d'isolement 34.

Ensuite, comme l'illustre la figure 4C, on fait croître par épitaxie sélective uniquement sur la surface 362 de la région monocristalline 32 une couche sacrificielle 38 de silicium-germanium puis une couche 40 de silicium. La hauteur h d'abaissement de la surface de la région 32 a été choisie en fonction des épaisseurs des couches 38 et 40 de façon que la surface supérieure de la couche de Si 40 atteigne sensiblement le niveau initial 361.

Lors de la croissance des couches de SiGe 38 et de Si 40, les parois sensiblement verticales des zones d'isolement périphériques 34 empêchent la formation de facettes décrite précédemment.

Le procédé se poursuit, comme l'illustre la figure 4D, par la formation sur la couche de Si 40 de la grille isolée 21 d'un transistor.

Ensuite, comme l'illustre la figure 4E, on procède à une gravure sélective des zones d'isolement 34. La surface supérieure des zones d'isolement 34 est abaissée à un niveau inférieur à la limite entre les couches 38 et 40. De préférence, la gravure des zones d'isolement 34 est effectuée de la hauteur h de retrait initial de la région 32 (figure 4B).

On notera que la gravure de la surface supérieure des zones d'isolement 34 n'implique aucune étape de masquage et qu'à la suite de cette gravure les bords de la couche sacrificielle 38 sont apparents. Cette couche peut donc être directement éliminée.

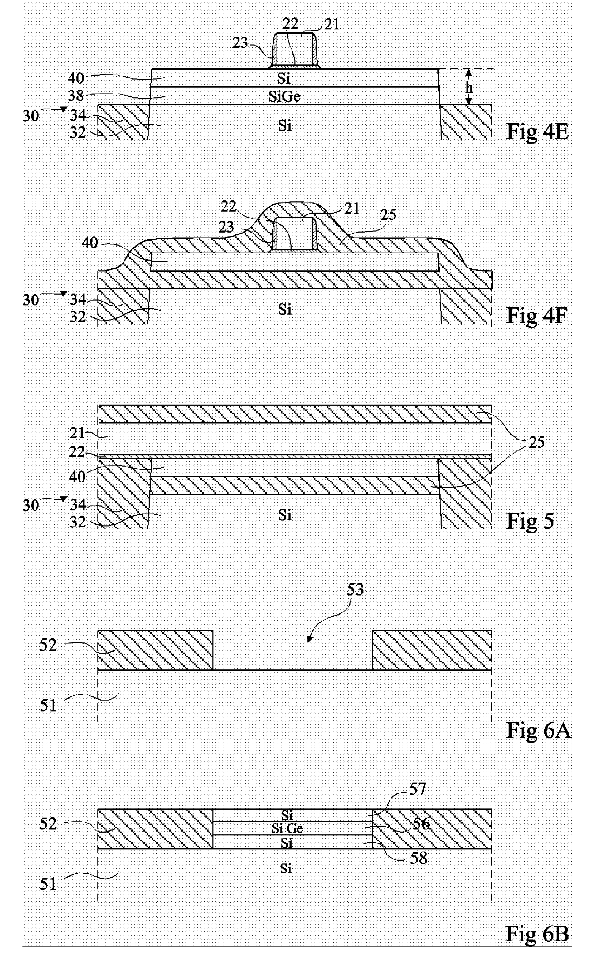

Aux étapes suivantes illustrées en figure 4F, on procède à une élimination sélective de la couche de silicium-germanium 38 et à son remplacement par tout élément approprié, par exemple un isolant 25.

On forme ainsi un transistor MOS dont la région de canal 40 présente une épaisseur fine comprise entre 5 et 20 nm, de préférence inférieure à 10 nm, par exemple de 6 à 7 nm et séparée par un isolant localisé 25 du substrat sous-jacent 32.

La figure 5 est une vue en coupe effectuée selon un plan (III-III', figure 2) parallèle à la direction d'extension de la grille 21, perpendiculaire à l'axe de coupe des figures 4A à 4F.

Comme l'illustre la figure 5, la grille 21 s'étend à l'aplomb de la région active 32 et s'appuie de part et d'autre de la région active 32 sur les régions d'isolement 34. La grille 21 est isolée du canal 40 sous-jacent par un isolant 22. Le canal 40 est séparé de la région active 32 par l'isolant 25.

Comme l'illustrent les figures 4F et 5, le canal 40 ainsi que l'isolant 25 présentent selon la présente invention des épaisseurs constantes. Le transistor résultant ne présente donc plus les dysfonctionnements des dispositifs connus.

Cela est obtenu grâce à la suppression selon la présente invention de la formation des facettes périphériques classiquement obtenues lors de la croissance de couches monocristallines minces telles que les couches SiGe 38 et Si 40 sur la tranche monocristalline 30.

La présente invention permet d'obtenir une ou des couches minces semiconductrices monocristallines sur un substrat dépourvues de facettes. L'absence de facettes permet de conserver pour les couches successives une surface plane égale à la surface initiale du substrat. Cela permet de réduire les surfaces d'intégration des gardes classiquement destinées à compenser la formation des facettes. Il est donc possible d'accroître la densité de dispositifs intégrés tels des mémoires à base de transistors CMOS.

De plus, un tel résultat est avantageusement obtenu selon la présente invention sans faire appel à la formation de masques supplémentaires. Les gravures selon la présente invention d'abaissement des surfaces de la région active 32 (figure 4B) et des zones d'isolement 34 (figure 4E) sont mises en oeuvres de façon autoalignée. Cela simplifie le procédé selon la présente invention par rapport aux procédés connus et évite la nécessité de prévoir des distances de garde, nécessaires dans le cas de masquages non autoalignés.

Bien entendu, la présente invention est susceptible de diverses variantes et modifications qui apparaîtront à l'homme de l'art. En particulier, seules les étapes nécessaires à la compréhension de la présente invention ont été décrites. L'homme de l'art saura compléter le procédé par toutes les étapes nécessaires à la réalisation du dispositif recherché. Ainsi, pour une région de canal telle que la couche 40 d'une épaisseur inférieure à la vingtaine de nanomètres, de préférence inférieure à la dizaine de nanomètres, par exemple de 6 à 7 nm, on souhaitera disposer de part et d'autre de la grille 21 de régions de source/drain qui présentent une épaisseur supérieure. Alors, l'homme de l'art saura mettre en oeuvre une épitaxie supplémentaire de façon à former de part et d'autre de la grille isolée 21 des régions surélevées de source/drain. Une telle épitaxie pourra prendre place après la formation de la grille 21 décrite en relation avec la figure 4D et avant la gravure sélective des zones d'isolement 34 décrites en relation avec la figure 4E.

Par ailleurs, l'homme de l'art saura apporter toutes modifications de matériau et d'épaisseur nécessaires dans une filière technologique donnée. En particulier, l'homme de l'art adaptera le matériau de l'espaceur 23 de la grille 21 de façon qu'il ne soit pas affecté par la gravure des zones d'isolement 34 décrite en relation avec la figure 4E.

En outre, on a décrit (figures 4B-C) que la hauteur h de gravure de la région 32 est choisie de façon que la surface supérieure de la couche supérieure de Si 40 atteigne le niveau initial 361 de la région 32. Selon une variante non représentée, la surface supérieure de la couche de Si 40 dépasse le niveau initial 361 de la région 32. Le cas échéant, l'homme de l'art saura adapter la hauteur h à la mise en oeuvre d'une épitaxie supplémentaire de drain/source après formation de la grille 21 de façon que la surface supérieure des drain/source atteigne ou dépasse le niveau initial 361.

Par ailleurs le processus décrit en relation avec les figures 4A à 4F ne constitue qu'un exemple de mise en oeuvre de la présente invention. Une variante des étapes initiales est illustrée en figures 6A et 6B.

Comme l'illustre la figure 6A, au lieu de partir d'une région active délimitée par des tranchées remplies d'un isolant, on part d'une couche ou substrat de silicium 51 sur laquelle on dépose une couche isolante (ou un empilement de couches) 52. Et on forme dans la couche 52 une ouverture 53 définissant une région active dans le silicium 51.

Comme l'illustre la figure 6B, on fait croître dans l'ouverture 53 des couches monocristallines de silicium-germanium 56 et de silicium 57, éventuellement sur une couche de silicium de base 58. On pourra ensuite, de façon analogue à ce qui a été décrit précédemment, graver partiellement ou totalement la couche isolante 52 pour accéder à la périphérie de la couche de silicium-germanium 56 et l'éliminer par gravure sélective.

De plus, l'homme de l'art comprendra que, si la présente invention n'a été décrite que dans le cadre de la formation d'un transistor MOS ayant une région de canal mince sur isolant, ceci ne constitue qu'un exemple d'application.

La présente invention peut être utilisée dans tout type de dispositif utilisant des couches semiconductrices sacrificielles destinées à être éliminées. Par exemple, la présente invention peut être utilisée pour former des transistors MOS du type grille tout autour (all around gate), des transistors MOS à double grille ou à grilles multiples...

De façon générale, bien que la présente invention ait été décrite dans le cadre d'une filière de silicium, elle s'applique à toute filière de fabrication de circuits intégrés.

## Revendications

1. Procédé de formation d'une portion de couche semiconductrice monocristalline (40 ; 57) au dessus d'une zone évidée, comprenant les étapes suivantes :
faire croître par épitaxie sélective sur une région active semiconductrice monocristalline (32 ; 58) une couche semiconductrice monocristalline sacrificielle (38 ; 56) et une couche semiconductrice monocristalline (40 ; 57),
éliminer la couche semiconductrice monocristalline sacrificielle (38 ; 56),
**caractérisé en ce que** la croissance épitaxiale est réalisée alors que la région active est entourée d'une couche isolante en surépaisseur (34 ; 52) et **en ce que** l'élimination de la couche semiconductrice monocristalline sacrificielle (38 ; 56) est effectuée par un accès résultant d'une élimination au moins partielle de la couche isolante en surépaisseur.

2. Procédé selon la revendication 1, dans lequel la région active semiconductrice monocristalline (32 ; 58) et la couche semiconductrice monocristalline (40 ; 57) sont en silicium, et la couche semiconductrice monocristalline sacrificielle (38 ; 56) est en silicium-germanium.

3. Procédé selon la revendication 1, dans lequel la région active (32) est initialement délimitée par une zone d'isolement (34) au même niveau que sa face supérieure, comprenant, avant l'épitaxie desdites couches, l'étape consistant à abaisser la surface supérieure (362) de ladite région active d'une hauteur (h) inférieure à la profondeur desdites zones d'isolement.

4. Procédé selon la revendication 3, dans lequel la hauteur (h) d'abaissement de la surface supérieure (362) de la région active (32) est sensiblement égale à la somme des épaisseurs des couches épitaxiées (38, 40).

5. Procédé selon la revendication 1, dans lequel la région active (32) est initialement délimitée par une zone d'isolement (34) formée au-dessus d'une couche ou substrat semiconducteur.

6. Procédé selon la revendication 1, dans lequel l'intervalle vide laissé par le retrait de la couche sacrificielle (38) est rempli d'un isolant (25).

7. Procédé selon la revendication 1, dans lequel l'intervalle vide laissé par le retrait de la couche sacrificielle (38) est rempli d'un matériau conducteur électrique ou thermique tel qu'un métal.

8. Procédé de formation d'un transistor MOS, comportant la formation d'une couche semiconductrice monocristalline (40) selon la revendication 1 destinée à constituer le canal du transistor.

9. Procédé selon la revendication 8, dans lequel le retrait de la couche sacrificielle (38 ; 56) est effectué après formation d'une grille isolée (21, 22, 23) sur ladite couche semiconductrice monocristalline (40 ; 57).

10. Procédé selon la revendication 8, dans lequel la formation de la grille (21, 22, 23) est suivie d'une étape de croissance épitaxiale d'un matériau semiconducteur monocristallin de même nature que celui du canal (40), destiné à constituer des zones de source/drain surélevées.

11. Procédé de formation d'un transistor MOS à plusieurs grilles, comportant un procédé de formation de couche semiconductrice monocristalline isolée selon la revendication 1.
